# EUROPEAN PATENT SPECIFICATION

(11) **EP 0 581 330 B1**
(45) Date of publication and mention of the grant of the patent: **27.03.1996**
(21) Application number: 93115437.1
(22) Date of filing: 25.09.1992
(51) Int. Cl.: B41J 2/345, B41J 2/45

(54) **Drive IC for printing head**
Integrierte Treiberschaltung für Druckkopf
Circuit intégré de commande pour tête d'impression

(30) Priority: 14.02.1992 JP 27623/92
(43) Date of publication of application: 02.02.1994
(62) Divisional of application: 92116466.1
(73) Proprietor: ROHM CO., LTD., Kyoto (JP)
(72) Inventor: Nagahata, Takaya, c/o Rohm Co., Ltd., Kyoto (JP); Shirasaki, Toshiyuki, c/o Rohm Co., Ltd., Kyoto (JP); Kishimoto, Tokihiko, c/o Rohm Co., Ltd., Kyoto (JP); Kishimoto, Yoshinobu, c/o Rohm Co., Ltd., Kyoto (JP)
(74) Representative: Reinhard - Skuhra - Weise & Partner

(56) References cited:
- WO-A-88/07729
- JP-A-02 003 343
- JP-A-02 108 561
- US-A- 4 963 886

## Description

This invention relates generally to a drive IC for incorporation in a printing head, particularly a line-type printing head, such as a thermal printing head and an LED printing head.

As disclosed in US-A-4963886 or JP-A-2-108561, a prior art drive IC for a printing head is rectangular with a pair of longer sides and a pair of shorter sides. The drive IC has a multiplicity of drive output pads adjacent to and along one longer side, and also a plurality of control signal pads and power grounding pads adjacent to and along the other longer side.

When incorporated in a line-type thermal printing head for example, the control signal pads and power grounding pads of the drive IC are connected, by wire bonding, to relevant conductor paths which are made to extend along a longitudinal edge of an insulating substrate. According to the prior art arrangement, since all of the control signal pads and power grounding pads are located adjacent to and along the same longer side of the drive IC, it is necessary to perform the wire bonding transverely of the IC longer side with respect to most of the control signal pads and power grounding pads (see Fig. 2 of JP-A-2-108561 for example). As a result, the conductor paths need be made to have very many bent portions extending transversely of the IC longer side for facilitating the wire bonding operation. Obviously, the presence of many bends in the conductor paths makes it difficult to form the conductor paths by pattern etching in addition to increasing the likelihood of noises.

Further, the bent portions of the conductor paths must be inevitably located in a striplike portion between the array of drive IC's and the relevant longitudinal edge of the insulating substrate. Thus, a power grounding path included in the conductor paths must be formed in the striplike portion in a manner not to overlap the bent portions of the other conductor paths. As a result, the width of the power grounding path need be reduced due to the presence of the bent portions, thereby failing to pass a sufficient drive current as required for generating enough heat.

It is, therefore, an object of the present invention to provide a drive IC which, in combination with in a printing head, facilitates formation of a conductor pattern on a substrate and enables reducing the required width of the substrate while also enabling passage of a sufficient drive current.

According to the present invention, there is provided a drive IC for a printing head, the drive IC being rectangular with first and second longer sides as well as first and second shorter sides, the drive IC having a multiplicity of drive output pads arranged adjacent to and along the first longer side, the drive IC also having control signal pads which include at least a data-in pad, a data-out pad, a strobe pad, a logic power supply pad and a clock pad, characterized in that: the control signal pads are arranged adjacent to the respective shorter sides.

Other objects, features and advantages of the present invention will become apparent from the following detailed description of the preferred embodiments given with reference to the accompanying drawings, in which:
Fig. 1 is a schematic plan view showing a printing head which incorporates a plurality of drive ICs according to the present invention;
Fig. 2 is a plan view showing the details of each drive IC;
Fig. 3 is a fragmentary plan view showing a left-hand end portion of the printing head shown in Fig. 1;
Fig. 4 is a fragmentary plan view showing a central portion of the same head; and
Fig. 5 is a fragmentary plan view showing a right-hand end portion of the same head.

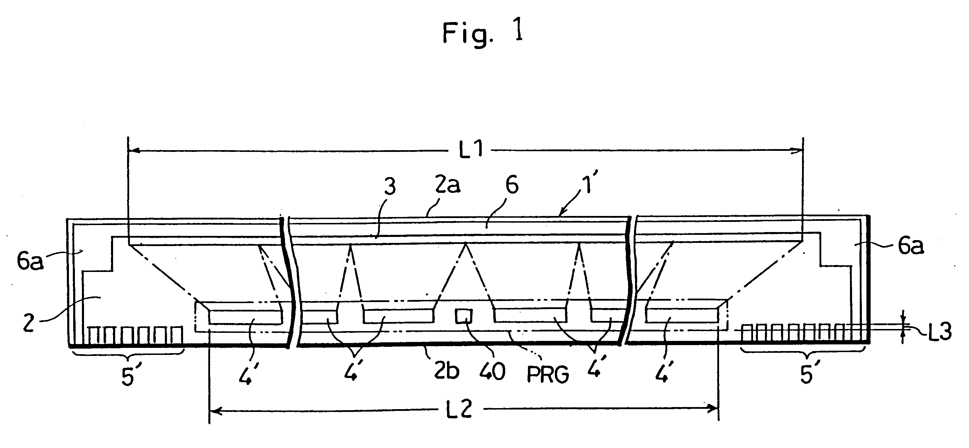

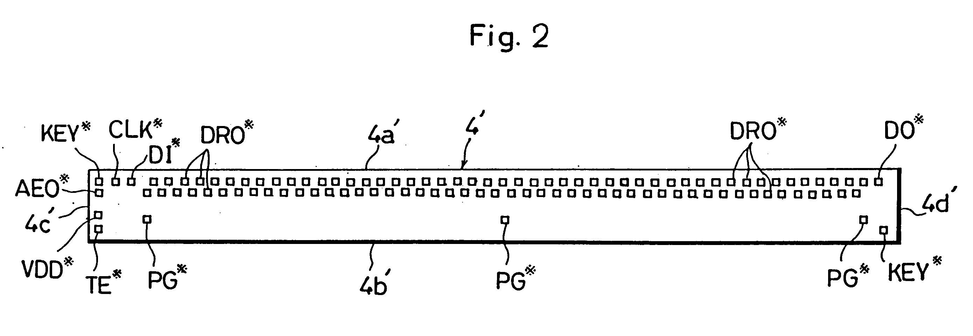

Figs. 1 and 3-5 of the accompanying drawings show a thermal printing head which incorporates a plurality of drive IC's 4' according to the present invention. On the other hand, the details of each drive IC 4' is shown in Fig. 2.

As shown in Figs. 1 and 3-5, the thermal head designated by reference numeral 1' includes an elongate head substrate 2 having a first longitudinal edge 2a and a second longitudinal edge 2b. The upper surface of the substrate 2 is formed with a heating resistor line 3 extending longitudinally of the substrate along the first longitudinal edge 2a, and an array of drive IC's 4' also extending longitudinally of the substrate along the second longitudinal edge 2b. The array of drive IC's 4' is enclosed in a protective resin body PRB.

The upper surface of the head substrate 2 is also formed with two groups of connection terminals 5' arranged in respective end portions of the substrate adjacent to the second longitudinal edge 2b. The upper surface of the head substrate is further formed with a common electrode 6 extending longitudinally of the substrate between the first longitudinal edge 2a and the resistor line 3. Each end 6a of the common electrode 6 extends transversely toward the second longitudinal edge 2b to provide a connection terminal in the corresponding terminal group.

The heating resistor line 3 has a length L1, and the array of drive IC's 4' is intentionally arranged in a smaller length L2, as shown in Fig. 1. The respective groups of connection terminals 5' are arranged locally in the respective excess end portions provided by such an arrangement. Thus, the respective groups of connection terminals 5' are located clear of the drive IC array longitudinally of the substrate 2 but overlap the protective resin body PRB transversely of the head substrate 2 by an amount L3.

On the other hand, the arrangement of the drive IC's 4' within the array is such that a wider spacing is provided between two central drive IC's, as clearly illustrated in Fig. 1. This wider spacing is utilized for mounting a single thermistor 40 at the longitudinal center of the substrate 2. Such a central arrangement of the thermistor 40 is preferred for insuring an accurate temperature detection because heat dissipation tends to be higher at the respective end portions of the substrate 2.

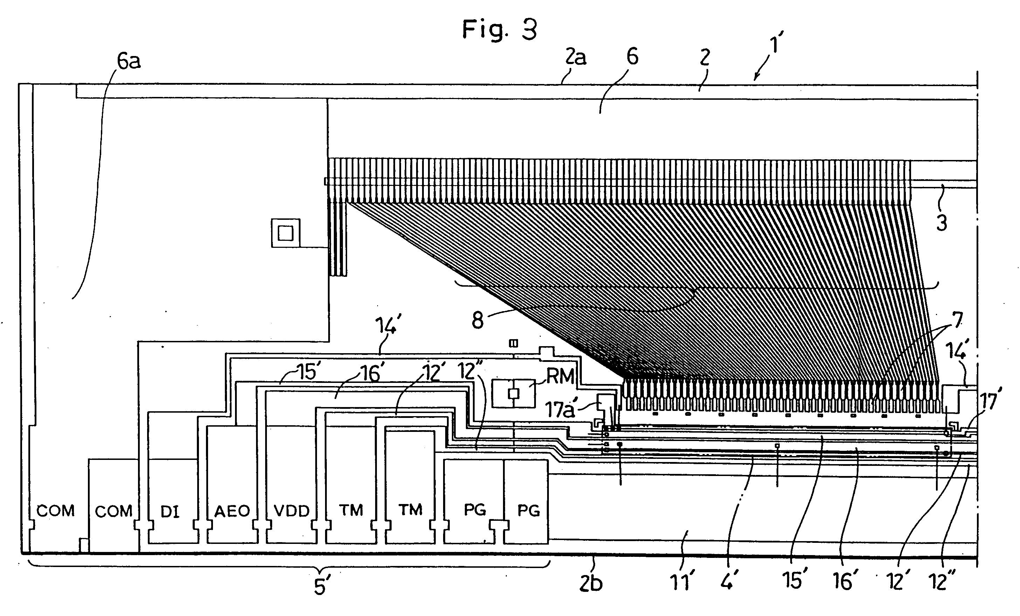

As shown in Figs. 3-5, groups of wire bonding pads 7 are formed on the upper surface of the head substrate 2 adjacent to the respective drive IC's 4' on the side thereof closer to the first longitudinal edge 2a. A multiplicity of individual electrodes 8 extend, in a slightly flaring pattern, from the respective groups of wire bonding pads 7 to a first series of comb-like teeth 9 crossing the heating resistor line 3. A second series of comb-like teeth 10, which also cross the resistor line 3, are arranged in staggered relation to the first series of comb-like teeth 9 and connected to the common electrode 6. Thus, the heating dots are provided by the respective portions of the resistor line 3 between the two kinds of comb-like teeth 9, 10.

As shown in Fig. 3, the group of connection terminals 5' located in the left-hand end portion of the head substrate 2 include, from left to right, two common terminals COM, a data-in terminal DI, a strobe terminal AEO, a logic power supply terminal VDD, two thermistor connection terminals TM, and two power grounding terminals PG. The common terminals COM and the power grounding terminals PG are plural for enabling passage of a sufficient current.

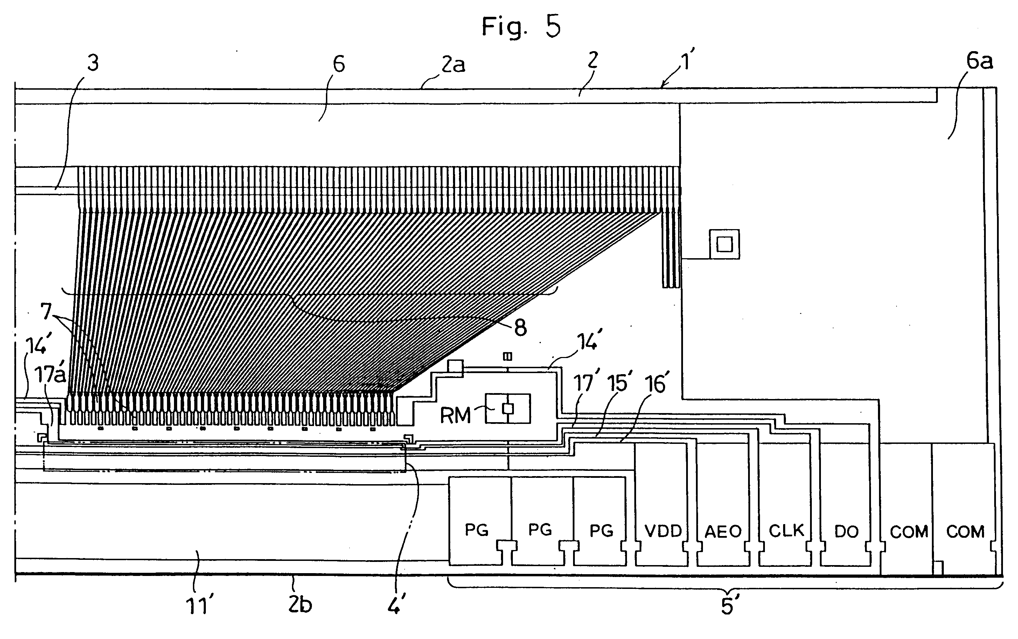

As shown in Fig. 5, the group of connection terminals 5' located in the right-hand end portion of the head substrate 2 include, from right to left, two common terminals COM, a data-out terminal DO, a clock terminal CLK, a strobe terminal AEO, a logic power supply terminal VDD and three power grounding terminals PG.

The data-out terminal DO may be omitted. Further, depending on various requirements, the number of common terminals COM and power grounding terminals PG may be increased or decreased, and other control signal terminals may be added.

The common terminals COM merge with the respective end portions 6a of the common electrode 6. The power grounding terminals PG are connected to a power grounding conductor path 11' which extends straight between the second longitudinal edge 2b of the head substrate 2 and the drive IC array 4'. In the illustrated embodiment, the power grounding conductor path 11 is made relatively wide to assume a major space of the strip-like portion between the second longitudinal edge 2b and the drive IC array 4' for enabling passage of a relatively large current.

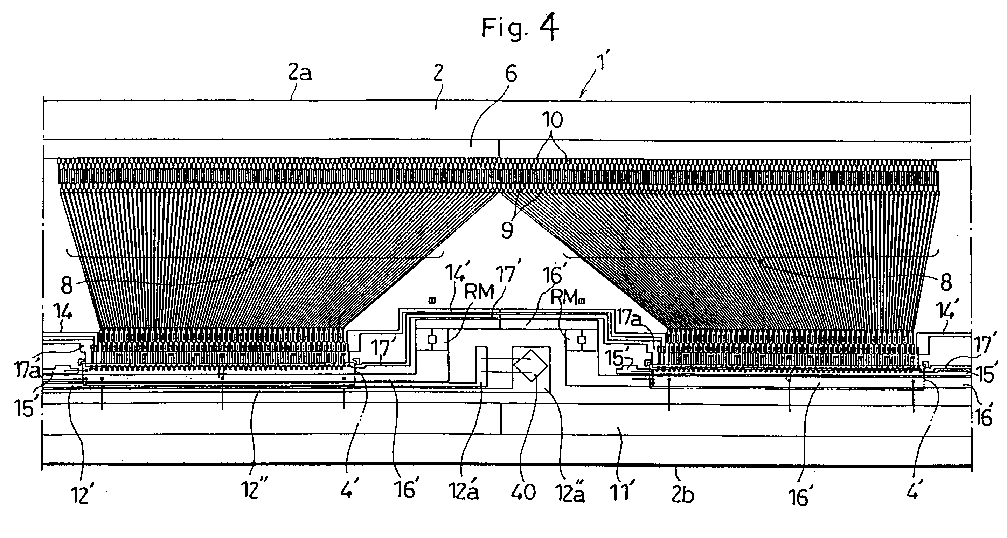

One of the thermistor connection terminals TM is connected to a first thermistor conductor path 12' extending substantially straight under the drive IC array 4'. The first thermistor conductor path 12' terminates in a wire bonding pad 12a' (Fig. 4) which is located at the longitudinal center of the substrate 2.

The other thermistor connection terminal TM is connected to a second thermistor conductor path 12'' extending substantially straight between the drive IC array 4' and the power grounding path 11'. The second thermistor conductor path 12'' terminates in a thermistor mounting pad 12a'' (Fig. 4) located also at the longitudinal center of the substrate 2. The thermistor 40 is mounted on the thermistor mounting pad 12a'' of the second thermistor conductor path 12'' and connected to the wire bonding pad 12a' of the first thermistor conductor path 12' by wire-bonding.

Each strobe terminal AEO is connected to a strobe conductor path 15' extending substantially straight under the drive IC array 4'. However, the strobe conductor path 15' is rendered discontinuous generally at the longitudinal center of the substrate 2, as shown in Fig. 4. Thus, the left half of the strobe conductor path 15' is used only for those of the drive IC's 4' located in the left half of the substrate, whereas the right half of the strobe conductor path 15' is used only for the remaining ones of the drive IC's 4' located in the right half of the substrate.

Each logic power supply terminal VDD is connected to a logic power supply conductor path 16' which also extends substantially straight under the drive IC array 4'. However, this conductor path 16' is formed in a bent pattern at the longitudinal center of the substrate 2 for circumventing the thermistor 40.

The single clock terminal CLK (Fig. 5) located in the right-hand end portion of the head substrate 2 is connected to a clock conductor path 17' which extends longitudinally of the substrate 2 under the respective drive IC's 4' and terminates at the left-hand end drive IC (Fig. 3). The clock conductor path 17' is substantially straight under each of the drive IC's 4' but bent transversely at suitable positions to provide wire bonding portions 17a'.

The data-in terminal DI (Fig. 3) and the data-out terminal DO (Fig. 5) are equally connected to a data conductor path 14' which is formed in a bent pattern to circumvent the other conductor paths. The data conductor path 14' is rendered discontinuous at the positions of the respective drive IC's 4'. Instead, the data conductor path 14' is connected in series or cascade with the respective drive IC's 4'.

As represented in Fig. 2, each drive IC 4' is rectangular with first and second longer sides 4a', 4b', and first and second shorter sides 4c', 4d'. The drive IC has a multiplicity of drive output pads DRO* arranged in two rows adjacent to the first longer side 4a'. These drive output pads are connected to the wire bonding pads 7 of the corresponding individual electrodes 8 by wire-bonding, as shown in Fig. 4.

As also illustrated in Fig. 2, each drive IC has additional pads which include three power grounding pads PG*, a data-in pad DI*, a data-out pad DO*, a strobe pad AEO*, a logic power supply pad VDD*, a clock pad CLK*, two positioning pads KEY*, and a test pad TE*. The details of these additional pads are described below.

The three power grounding pads PG* are located along and adjacent to the second longer side 4b' of the drive IC 4'. These power grounding pads are wire-bonded to the power grounding conductor path 11' (Figs. 3-5). It should be appreciated that the power grounding pads PG* may be provided in an optional number as long as they are located adjacent to the second longer side 4b' of the drive IC 4' for conveniently wire-bonding to the power grounding conductor path 11' which is located between the drive IC array and the second longitudinal edge 2b of the head substrate 2.

The data-in pad DI* is located adjacent to the first longer side 4a' and first shorter side 4c' of the drive IC 4', whereas the data-out pad DO* is located adjacent to the first longer side 4a' and second shorter side 4d' of the drive IC. The data-in and data-out pads DI*, DO* are wire-bonded to the discontinuous data conductor path 14' to realize cascade connection between the respective drive IC's (Figs. 3-5).

The strobe pad AEO* is located adjacent to the first shorter side 4c' of the drive IC 4'. Such a location is selected for conveniently wire-bonding, in the longitudinal direction of the drive IC, to the strobe conductor path 15' which is made to extend under the drive IC. Of course, the strobe pad AEO* may be alternatively located adjacent to the second shorter side 4d' of the drive IC.

The logic power supply pad VDD* is also located adjacent to the first shorter side 4c' of the drive IC 4' for conveniently wire-bonding, again in the longitudinal direction of the drive IC, to the logic power supply conductor path 16' which is made to extend under the drive IC. Of course, the power supply pad VDD* may be alternatively located adjacent to the second shorter side 4d' of the drive IC.

One of the positioning pads KEY* is located adjacent to the first longer side 4a' and first shorter side 4c' of the drive IC 4, whereas the other positioning pad is located adjacent to the second longer side 4b' and second shorter side 4d' of the drive IC. These positioning pads are used only for accurately mounting the drive IC relative to predetermined reference marks RM (Figs. 3-5) on the head substrate 2, so that they are not wire-bonded to any conductor path. Further, the positioning pads may be omitted because positional adjustment of the drive IC may be performed by utilizing selected corners of the drive IC. It should be appreciated that the positioning pads are shown only in Figs. 3 and 5 but not in Fig. 4 for the convenience of illustration.

The test pad TE* is located adjacent to the second longer side 4b' and first shorter side 4c' of the drive IC 4'. This test pad is used only for checking the performance of the drive IC before actual mounting. Thus, the test pad is not wire-bonded to any conductor path, and the position of the test pad is not at all important. If necessary, the test pad may be omitted because it has no direct relation with the operation of the drive IC.

Apparently, the respective positions of the data-in pad DI* and data-out pad DO* may be exchanged if the respective positions of the data-in terminal DI and data-out terminal DO are also exchanged. Similarly, the respective positions of the strobe pad AEO*, logic power supply pad VDD* and clock pad CLK* (plus the positioning pads KEY* and test pad TE* as well) may be also exchanged if the relevant conductor paths 15'-17' together with the relevant connection terminals AEO, VDD, CLK are suitably rearranged. An important point resides in that the control signal pads including DI*, DO*, AEO*, VDD* and CLK* for example are located adjacent to one or both of the shorter sides 4c', 4d' of the drive IC 4'.

According to the arrangement described above, since each drive IC 4' has its control signal pads DI*, DO*, AEO*, VDD* and CLK* located adjacent to the respective shorter sides 4c', 4d', the relevant conductor paths 14'-17' can be formed to extend under the drive IC and/or near the first longer side 4a' of the drive IC. In other words, the conductor paths 14'-17' associated with these control signal pads DI*, DO*, AEO*, VDD* and CLK* need not be necessarily formed in the strip-like portion between the drive IC array and the second longitudinal edge 2b of the substrate 2. Thus, the majority of that strip-like portion (even if rendered narrow) can be utilized for forming the power grounding conductor path 11' with a sufficient width (as required for passing a relatively large current) while also reducing the overall width of the thermal head 1'.

Secondly, due to the above-described arrangement of the control signal pads DI*, DO*, AEO*, VDD* and CLK*, the relevant conductor paths 14'-17' together with the power grounding path 11' can be made to extend as straight as possible. As a result, patterning of these conductor paths is greatly simplified to increase the productivity and yield. Further, due to the reduction of bending and/or branching portions, the conductor paths can be as short as possible to decrease the voltage drop and noises.

## Claims

1. A drive IC for a printing head, the drive IC being rectangular with first and second longer sides (4a', 4b') as well as first and second shorter sides (4c', 4d'), the drive IC (4') having a multiplicity of drive output pads (DRO*) arranged adjacent to and along the first longer side (4a'), the drive IC (4') also having control signal pads which include at least a data-in pad (DI*), a data-out pad (DO*), a strobe pad (AEO*), a logic power supply pad (VDD*) and a clock pad (CLK*), characterized in that:
the control signal pads (DI*, DO*, AEO*, VDD*, CLK*) are arranged adjacent to the respective shorter sides (4c', 4d').

2. The drive IC according to claim 1, further comprising a plurality of power grounding pads (PG*) arranged adjacent to the second longer side (4b').

## Patentansprüche

1. Treiber-IC für einen Druckkopf, wobei das Treiber-IC rechteckig mit einer ersten und zweiten längeren Seite (4a', 4b') sowie einer ersten und zweiten kürzeren Seite (4c', 4d') ausgebildet ist, wobei das Treiber-IC (4') eine Vielzahl an Treiber-Ausgangskontaktstellen (DRO*), welche nahe an und entlang der ersten längeren Seite (4a') angeordnet sind, sowie Steuersignal-Kontaktstellen aufweist, welche wenigstens eine Dateneingangs-Kontaktstelle (DI*), eine Datenausgangs-Kontaktstelle (DO*), eine Strobe-Kontaktstelle (AEO*), eine logische Versorgungskontaktstelle (VDD*) sowie eine Takt-Kontaktstelle (CLK*) enthalten,
**dadurch gekennzeichnet, daß**
die Steuersignal-Kontaktstellen (DE*, DO*, AEO*, VDD*, CLK*) nahe an den jeweiligen kürzeren Seiten (4c', 4d') angeordnet sind.

2. Treiber-IC nach Anspruch 1,
**dadurch gekennzeichnet, daß**
es ferner eine Vielzahl an Stromversorgungs-Erdungskontaktstellen (PG*) aufweist, die nahe an der zweiten längeren Seite (4b') angeordnet sind.

## Revendications

1. Circuit intégré de commande pour tête d'impression, le circuit intégré de commande ayant une forme rectangulaire présentant un premier et un second grands côtés (4a', 4b') et un premier et un second petits côtés (4c', 4d'), le circuit intégré de commande (4') comportant plusieurs protubérances de sortie de commande (DRO*) disposées au voisinage et le long du premier grand côté (4a'), le circuit intégré de commande (4') comportant aussi des protubérances de signal de commande qui comprennent au moins une protubérance d'entrée de données (DI*), une protubérance de sortie de données (DO*), une protubérance d'impulsions (AEO*), une protubérance d'alimentation en courant de circuit logique (VDD*) et une protubérance d'horloge (CLK*), caractérisé en ce que les protubérances de signal de commande (DI*, DO*, AEO*, VDD*, CLK*) sont disposées au voisinage des petits côtés respectifs (4c', 4d').

2. Circuit intégré de commande selon la revendication 1, comprenant en outre plusieurs protubérances de mise à la terre de courant (PG*) disposées au voisinage du second grand côté (4b').
